Europäisches Patentamt

European Patent Office

Office européen des brevets

(19)

(11) **EP 1 447 913 A1**

(12) **EUROPÄISCHE PATENTANMELDUNG**

(43) Veröffentlichungstag:
**18.08.2004 Patentblatt 2004/34**

(51) Int Cl.[7]: **H03M 1/10**

(21) Anmeldenummer: **04001903.6**

(22) Anmeldetag: **29.01.2004**

(84) Benannte Vertragsstaaten:
**AT BE BG CH CY CZ DE DK EE ES FI FR GB GR
HU IE IT LI LU MC NL PT RO SE SI SK TR**
Benannte Erstreckungsstaaten:
**AL LT LV MK**

(30) Priorität: **13.02.2003 DE 10305972**

(71) Anmelder: **Micronas GmbH
79108 Freiburg (DE)**

(72) Erfinder:
• **Temerinac, Miodrag
  79194 Gundelfingen (DE)**
• **Greitschus, Norbert
  79346 Endingen (DE)**

(74) Vertreter:
**Patentanwälte Westphal, Mussgnug & Partner
Am Riettor 5
78048 Villingen-Schwenningen (DE)**

(54) **Kompensationsschaltungsanordnung und Kompensationsverfahren zum Kompensieren von nicht-linearen Verzerrungen eines AD-Wandlers**

(57) Die Erfindung bezieht sich auf eine Kompensationsschaltungsanordnung (1-6) zum Kompensieren von nicht-linearen Verzerrungen eines AD-Wandlers (1) (AD: Analog/Digital) mit einem Signaleingang und einer Kompensationsanordnung.

Um hohe Kosten für ein aufwendiges Analogdesign des AD-Wandlers (1) und/oder um in diesem und der Kompensationsanordnung einen hohen Energieverbrauch zu vermeiden, wird vorgeschlagen, als Kompensationsschaltungsanordnung eine Kompensationsschaltung (2) aus digitalen Schaltungselementen zu verwenden, welche dem AD-Wandler (1) nachgeschaltet ist und ein nicht-linear-verzerrtes Ausgangssignal des AD-Wandlers (1) zum Kompensieren der nicht-linearen Verzerrung zugeführt bekommt. Zum Kompensieren werden dabei bevorzugt adaptive Koeffizienten verwendet.

FIG 1

**Beschreibung**

Die Erfindung bezieht sich auf eine Kompensationsschaltungsanordnung zum Kompensieren von nicht-linearen Verzerrungen eines AD-Wandlers (AD: Analog/Digital) mit den oberbegrifflichen Merkmalen des Patentanspruchs 1 bzw. auf ein Kompensationsverfahren zum Kompensieren von nicht-linearen Verzerrungen eines AD-Wandlers.

AD-Wandler sind ein kritischer Teil in integrierten Schaltungen mit gemischter, d. h. analoger und digitaler, Signalverarbeitung. Die Anforderungen bezüglich der Linearität des AD-Wandlers sind bei den üblichen Toleranzen der analogen Bauelemente sehr schwer zu erreichen. Die dafür benötigten Maßnahmen im Bereich des Analogdesigns verursachen hohe Kosten und/oder eine hohe Stromaufnahme der Schaltungsanordnung.

Zum Vermeiden nicht-linearer Verzerrungen bei der Analog-Digital-Wandlung der AD-Wandler werden Kompensationsanord-, nungen zum Kompensieren solcher nicht-linearer Verzerrungen des AD-Wandlers verwendet, wobei solche Kompensationsanordnungen einen Analogsignaleingang aufweisen. Üblicherweise sind sie eingangsseitiger Bestandteil des AD-Wandlers.

Die Aufgabe der Erfindung besteht darin, eine Kompensationsschaltungsanordnung zum Kompensieren von nicht-linearen Verzerrungen eines AD-Wandlers vorzuschlagen, welche ein vereinfachtes Gesamt-Analogdesign bei vorzugsweise auch verringerter Stromaufnahme ermöglicht.

Diese Aufgabe wird durch eine Kompensationsschaltungsanordnung zum Kompensieren von nicht-linearen Verzerrungen eines AD-Wandlers mit den Merkmalen des Patentanspruchs 1 bzw. ein Verfahren zum Kompensieren von nicht-linearen Verzerrungen eines AD-Wandlers mit den Merkmalen des Patentanspruchs 18 gelöst.

Vorteilhafterweise kann eine Kompensationsschaltungsanordnung zum Kompensieren von nicht-linearen Verzerrungen eines AD-Wandlers mit einem Signaleingang und einer Kompensationsanordnung aus digitalen Schaltungselementen zum digitalen Kompensieren der nicht-linearen Verzerrungen ausgebildet werden, wobei der Signaleingang als Kompensationseingang ein Digitalsignaleingang zum Zuführen eines vom AD-Wandler verzerrt ausgegebenen Signals ist. Durchgeführt wird somit eine nachträgliche digitale Kompensation bzw. Entzerrung der nicht-linearen Verzerrungen eines vorgeschalteten AD-Wandlers. Dafür erforderliche digitale Schaltungselemente sind kostengünstig und mit einem einfachen Digital-Schaltungsdesign bereitstellbar. Hohe Kosten oder eine erhöhte Stromaufnahme im Bereich einer dem AD-Wandler vorgeschalteten oder integrierten Kompensationsanordnung sind somit nicht erforderlich.

Verfahrensgemäß wird somit nach einer Analog-Digital-Wandlung in dem AD-Wandler mit einer Ausgabe eines nicht-linear verzerrten Digitalsignals nachträglich eine Kompensation im digitalen Schaltungsabschnitt vorgenommen.

Vorteilhafte Ausgestaltungen sind Gegenstand abhängiger Ansprüche.

Ein Ausführungsbeispiel und Modifikationen dazu werden nachfolgend anhand der Zeichnung näher erläutert. Es zeigen:

Fig. 1   Grundelemente der Kompensationsschaltungsanordnung zum Kompensieren von nicht-linearen Verzerrungen eines AD-Wandlers;

Fig. 2   eine Schaltungsanordnung zum Bestimmen eines Testsignals;

Fig. 3   eine Schaltungsanordnung zur iterativen Berechnung von Korrektur-Koeffizienten und

Fig. 4   eine alternative Schaltungsanordnung zur iterativen Bestimmung der Korrektur-Koeffizienten mit einer Nachschlagtabelle.

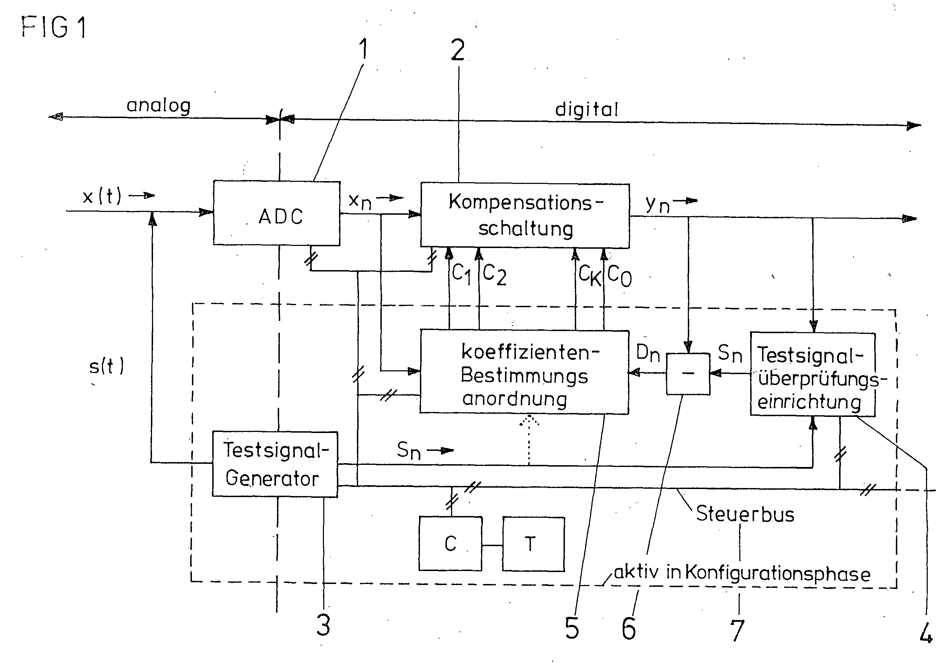

Wie dies aus Fig. 1 ersichtlich ist, besteht die beispielhafte Kompensationsschaltungsanordnung aus einem in der Darstellung linksseitigen analogen Abschnitt und einem in der Darstellung rechtsseitigen digitalen Abschnitt. Einem AD-Wandler ADC/1 (AD: Analog/Digital) wird ein analoges Eingangssignal x(t) zugeführt. Aus dem Ausgang des AD-Wandlers 1 wird nach der Analog-Digital-Wandlung eine digitale Zeichenfolge $x_n$ ausgegeben, welche dem analogen Eingangssignal x(t) entspricht. Aufgrund der Verwendung eines herkömmlichen AD-Wandlers 1 ist die aus diesem ausgegebene digitale Folge $x_n$ nicht-linear verzerrt. Der Index n steht für die Folge von Abtastwerten $x_n$, n = 0, 1, 2, ....

Die AD-gewandelte Abfolge $x_n$ wird nachfolgend dem Eingang einer Kompensationsschaltung 2 zugeführt. Die Kompensationsschaltung 2 kompensiert bzw. entzerrt die nicht-lineare Verzerrung, welche durch den AD-Wandler 1 entstanden ist. Von der Kompensationsschaltung 2 wird letztendlich eine Abfolge kompensierter digitaler Daten $y_n$ als Ausgangsdatenfolge ausgegeben.

Um die Kompensation durchführen zu können, werden der Kompensationsschaltung 2 Koeffizienten $c_1$, $c_2$, ... $c_K$, $c_0$ zugeführt, welche entsprechend dem nicht-linearen Verzerrungsverhalten des AD-Wandlers 1 bestimmt oder berechnet wurden. Der Index k = 1, 2, ..., K dient dabei als Laufindex für die Koeffizienten $c_k$ der Kompensation.

Mit der derart aufgebauten Schaltungsanordnung aus dem AD-Wandler 1 mit der nachgeschalteten Kompensationsschaltung 2, welcher der Satz aus Koeffizienten $c_1$, ... $c_K$ zugeführt wird, ist somit ein einfacher Aufbau bereitgestellt, welcher eine Analog-Digital-Wandlung eines analogen Signals x(t) zu einer nicht nicht-linear verzerrten Abfolge kompensierter digitaler Daten $y_n$ ermöglicht.

Zum Bestimmen der Koeffizienten $c_1$, ... $c_K$ dienen zusätzliche Bauelemente der Schaltungsanordnung, welche in dem gestrichelt umrahmten Abschnitt dargestellt sind. Diese zusätzlichen Bauelemente sind zweckmäßigerweise nur während einer Konfigurationsphase aktiv. Alternativ zu dieser nachfolgend beschriebenen Schaltungsanordnung ist auch der Einsatz eines Speichers möglich, in welchem ein einmalig zuvor bestimmter Satz aus Koeffizienten $c_1$, ... $c_K$ hinterlegt ist, welcher generell für die Kompensation einsetzbar ist. Bevorzugt wird jedoch der nachfolgend beschriebene Schaltungsaufbau, welcher eine Anpassung der Koeffizienten $c_1$, ... $c_K$ an die tatsächlichen und/oder momentanen Bedingungen ermöglicht.

Bei der beispielhaft dargestellten Schaltungsanordnung wird von einem Testsignal-Generator 3 ein Testsignal s(t) erzeugt und in der Konfigurationsphase an den Eingang des AD-Wandlers 1 angelegt. Der Testsignal-Generator 3 stellt außerdem entweder die Parameter $s_n$ zur Erzeugung des analogen Testsignals s(t) oder eine diesem analogen Testsignal s(t) entsprechende Abfolge digitaler Testsignal-Daten $S_n$ bereit. Diese Parameter $s_n$ oder Testsignal-Daten $S_n$ werden einer Koeffizienten-Bestimmungsanordnung 5 und/oder einer Testsignal-Überprüfungseinrichtung 4 zugeführt.

Außerdem weist die Schaltungsanordnung eine Koeffizienten-Bestimmungsanordnung 5 zum Bestimmen der durch die Kompensationsschaltung zu verwendenden Koeffizienten $c_1$, ... $c_K$ auf. Neben einem Ausgang zum Übergeben der bestimmten Koeffizienten $c_1$, ... $c_K$, $c_0$ an die Kompensationsschaltung 2 weist die Koeffizienten-Bestimmungsanordnung 5 einen Eingang auf, welchem die Abfolge digitaler Daten $x_n$ des AD-Wandlers 1 zugeführt wird. Ferner weist die Koeffizienten-Bestimmungsanordnung 5 einen Eingang auf, welchem Verzerrungs- bzw. Differenzdaten $D_n$ zugeführt werden. Die Differenzdaten $D_n$ werden von einem Subtraktionsglied 6 bereitgestellt, welchem die Abfolge kompensierter digitaler Daten $y_n$ vom Ausgang der Kompensationsschaltung 2 zugeführt wird. Das Subtraktionsglied 6 bekommt außerdem direkt oder über die Testsignal-Überprüfungseinrichtung 4 eine Abfolge digitaler Signaldaten $S_n$ zugeführt. Die Abfolge digitaler Signaldaten $S_n$ entspricht in der Konfigurationsphase einer Signalabbildung des Testsignals, wobei diese Signalabbildung nach geeigneter Koeffizientenbestimmung möglichst oder idealerweise ganz unverzerrt ist.

Während der Konfigurationsphase wird somit vom Testsignal-Generator 3 das analoge Testsignal s(t) erzeugt und dem AD-Wandler 1 zugeführt. Dieser führt eine Analog-Digital-Wandlung zu der Abfolge digitaler Daten $x_n$ durch, welche einerseits der Kompensationsschaltung 2 und andererseits der Koeffizienten-Bestimmungsanordnung 5 zugeführt werden. Bei noch nicht vorhandenem Satz von Koeffizienten $c_1$, ... $c_K$ gibt die Kompensationsschaltung 2 als Abfolge kompensierter digitaler Daten $y_n$ die von dem AD-Wandler 1 verzerrte Abfolge digitaler Daten $x_n = y_n$ aus. Diese wird dem Subtraktionsglied 6 zugeführt, welches auch eine entsprechende Abfolge digitaler Testsignal-Daten $S_n$ zugeführt bekommt, welche einem unverzerrten Datensatz entsprechen. Nach einer Subtraktion der beiden Abfolgen von Daten ($y_n - S_n$) wird der Koeffizienten-Bestimmungsanordnung 5 die Abfolge von Daten des Differenzsignals $D_n$ zugeführt. Mit diesen Daten bestimmt die Koeffizienten-Bestimmungsanordnung 5 einen Satz Koeffizienten $c_1$, ... $c_K$, $c_0$, welcher der Kompensationsschaltung 2 zur zukünftigen Kompensation zugeführt wird.

Nachfolgend wird gemäß bevorzugter Ausführungsform vom Testsignal-Generator 3, der auch aus einem Speicher mit einem analogen Testsignal s(t) und einem digitalen entsprechenden Parametersatz $s_n$ bestehen kann, erneut ein Testsignal s(t) zum AD-Wandler 1 geführt. Die von dem AD-Wandler 1 erzeugte Abfolge digitaler Daten $x_n$ wird daraufhin von der Kompensationsschaltung 2 gemäß dem dieser zugeführten Satz aus Koeffizienten $c_1$, ... $c_K$ kompensiert, so dass die Abfolge kompensierter digitaler Daten $y_n$ im Idealfall bei bereits optimal bestimmten Koeffizienten $c_1$, ... $c_K$ ohne nicht-lineare Verzerrung ausgegeben wird. Die Abfolge kompensierter digitaler Daten $y_n$ wird wiederum dem Subtraktionsglied 6 zugeführt, in welchem nach Subtraktion mit den entsprechenden Werten der Abfolge digitaler Testsignal-Daten $S_n$ wiederum die Abfolge von Daten $D_n$ des Differenzsignals erzeugt wird. Diese Differenzdaten $D_n$ werden der Koeffizienten-Bestimmungsanordnung 5 wieder zugeführt, welche in dem Fall, dass die Differenzdaten $D_n$ ungleich Null sind oder vorgegebene Schwellenwerte übersteigen, eine erneute oder bevorzugt eine iterativ verbesserte Koeffizienten-Bestimmung zum Bereitstellen verbesserter Koeffizienten $c_1$, ... $c_K$ durchführt.

Nach der Bestimmung eines ausreichend entzerrenden bzw. kompensierenden Satzes von Koeffizienten $c_1$, ... $c_K$ wird die Konfigurationsphase beendet, woraufhin durch die Schaltungsanordnung aus AD-Wandler 1 und Kompensationsschaltung 2 eine Umwandlung und Kompensation eines analogen Signals x(t) zu einer Abfolge kompensierter digitaler Daten $y_n$ durchgeführt wird.

Zweckmäßigerweise wird in regelmäßigen Abständen eine Konfigurationsphase eingeleitet, um den verwendeten Satz von Koeffizienten $c_1$, ... $c_K$ bezüglich der Aktualität zu überprüfen. Auf diese Art und Weise können driftende nicht-lineare Verzerrungen durch beispielsweise eine Erwärmung der Schaltungsanordnung oder sonstige Störeinflüsse aus der Umgebung ausgeglichen werden.

Die Konfigurationsphase wird entsprechend den Anforderungen genügend oft ein- und ausgeschaltet, so dass eventuelle langsame Veränderungen der nicht-linearen Verzerrungen rechtzeitig erkannt und kompensiert werden können. Dabei ist natürlich auch eine Vorausbestimmung und Berücksichtigung zu erwartender weiterer Verschlechterungen oder Verbesserungen bei der Entwicklung der Verzerrungen prinzipiell möglich.

Zum Steuern der Kompensationsschaltungsanordnung wird vorteilhafterweise eine Steuereinrichtung C verwendet, die mit einer Zeitüberwachungseinrichtung, insbesondere einem Zeitgeber T, verbunden ist. Neben dem Ein- und Ausschalten der Konfigurationsphase steuert die Steuereinrichtung C auch die einzelnen Komponenten über z. B. Bus 7.

Möglich ist insbesondere auch die Bereitstellung verschiedenartiger Testsignale s(t), $s_n$ für verschiedene Anwendungsbereiche der Schaltungsanordnung, so dass die Koeffizienten $c_1$, ... $c_K$ beispielsweise optimal auf ein niederfrequentes oder auf ein hochfrequentes analoges Signal x(t) angepasst werden können.

Nachfolgend werden die einzelnen Schaltungskomponenten sowie Verfahrensabläufe unter Bezug auf die mathematischen Hintergründe näher betrachtet.

Ausgegangen wird dabei für die Konfigurationsphase von einem analogen Testsignal

s(t),

welchem nach einer Analog-Digital-Wandlung ohne eine nicht-lineare Verzerrung die theoretischen, unverfälschten Abtastwerte

$$S_n = s\left(\frac{n}{Fs}\right),$$

entsprechen, welche wiederum nach einer optimalen Kompensation als Abfolge kompensierter digitaler Daten $y_n$ aus der Kompensationsschaltung 2 ausgegeben werden sollten. Dabei sind n ein Laufindex aus der Menge der natürlichen Zahlen und $F_s$ die Abtastfrequenz des AD-Wandlers 1.

Nach der Zuführung des analogen Testsignals s(t) zu dem AD-Wandler 1 und der Analog-Digital-Wandlung in diesem wird an dessen Ausgang die Abfolge digitaler Daten $x_n$ bereitgestellt gemäß

$$x_n = s_n + d_n.$$

Die Abfolge digitaler Daten $x_n$ entspricht somit der Summierung der korrekten theoretischen und unverfälschten Abtastwerte $s_n$ und einem jeweiligen Verzerrungs-Datenwert $d_n$, welcher der entsprechenden Verzerrung durch den AD-Wandler 1 entspricht.

Die digitale Kompensationsschaltung 2, welche unter Einsatz der Koeffizienten $c_1$, ... $c_K$ aus der verzerrten Abfolge digitaler Daten $x_n$ die letztendlich auszugebende Abfolge kompensierter digitaler Daten $y_n$ erzeugt, muss somit eine Kompensation mit einer Kennlinie durchführen, welche durch ein Polynom K-ter Ordnung beschrieben werden kann:

$$(1) \quad y_n = \sum_{k=l}^{K} c_k \cdot x_n^k = v \cdot s_n + D_n = S_n + D_n .$$

Dabei entsprechen die Koeffizientenwerte $c_k$ mit k = 1, 2, ... K adaptiven Koeffizienten, d. h. Koeffizienten, welche nach Bedarf angepasst werden. Das Ausgangssignal bzw. die Abfolge von ausgegebenen kompensierten digitalen Daten $y_n$ beinhaltet eine Abbildung des Testsignals bzw. der Abfolge der digitalen Testsignal-Daten $S_n$ zuzüglich einer möglicherweise gegebenen Veränderung v, insbesondere Verstärkung oder Dämpfung. Die Abfolge der kompensierten digitalen Daten $S_n$ ist somit als Produkt aus einem Verzerrungsfaktor v und der Abfolge digitaler Testsignal-Daten $s_n$ beschreibbar gemäß

$$S_n = v \cdot S_n,$$

wobei die effektiven Verzerrungen der Schaltungsabfolge aus dem AD-Wandler 1 und bei nicht ausreichender Kompensation der Kompensationsschaltung 2 durch die Abfolge der Differenzdaten $D_n$ beschrieben werden kann gemäß

$$(2)\ D_n = y_n - S_n.$$

Da die Parameter $s_n$ des Testsignals bekannt sind, kann von der Testsignal-Überprüfungseinrichtung 4 aus der Abfolge kompensierter digitaler Daten $y_n$ die Abfolge der Ausgangssignal-Daten $S_n$ extrahiert werden, so dass mittels des Subtraktionsgliedes 6 die eigentlichen Verzerrungs- bzw. Differenzdaten $D_n$ in den Daten $y_n$ am Ausgang der Kompensationsschaltung 2 berechnet werden können. Außerdem können die Gradienten der quadratischen Verzerrung berechnet werden gemäß

$$\frac{\partial D_n^2}{\partial c_k} = 2 \cdot (y_n - S_n) \cdot x_n^k = 2 \cdot D_n \cdot x_n^k.$$

Mit Hilfe eines iterativen Verfahrens ist es möglich, den Satz aus Koeffizienten $c_k$ konvergieren zu lassen. Dazu kann der Ansatz

$$(3)\ c_k^{\,n+1} = c_k^{\,n} - G \cdot D_n \cdot x_n^k$$

gewählt werden, so dass letztendlich die quadratische Verzerrung bzw. Leistung minimiert wird. In der Formel (3) ist als Stabilitätskriterium ein Parameter G eingeführt, welcher zugleich eine möglichst hohe Konvergenzgeschwindigkeit leisten soll. $c_k^{\,n}$ beschreibt dabei den Wert des Koeffizienten $c_k$ im n-ten Iterationsschritt, wobei der Koeffizient der Kompensation $c_k$ wiederum den Laufindex $k = 1, ..., K$ hat. Die Iterationsschritte werden vorzugsweise ab dem Wert Null gezählt, so dass gilt $n = 0, 1, ...$.

Gemäß besonders bevorzugter Ausführungsform wird als Testsignal s(t) vorzugsweise ein sinusförmiges Testsignal $s(t) = \sin[2\pi t]$ verwendet, um-eine nicht-lineare Kompensation durchzuführen, weil die Struktur der Verzerrungen durch den AD-Wandler 1 und möglicherweise weitere Verzerrungen durch die Kompensationsschaltung 2 damit einfach ermittelbar sind. Ein nicht-linear verzerrender AD-Wandler 1 mit dem Sinus-Eingangssignal auf einer Frequenz $F_t$ produziert Oberwellen auf Frequenzen $p \cdot F_t$, welche wegen der Abtastung heruntergefaltet werden können zu

$$f_k = \begin{cases} \left(p \cdot F_t\right)_{\mathrm{mod}\ Fs} & \left(p \cdot F_t\right)_{\mathrm{mod}\ Fs} \leq \dfrac{F_s}{2} \\[4mm] F_s - \left(p \cdot F_t\right)_{\mathrm{mod}\ Fs} & \left(p \cdot F_t\right)_{\mathrm{mod}\ Fs} \geq \dfrac{F_s}{2} \end{cases}.$$

Dabei ist $p = 2, 3, ..., M$ Laufindex der Frequenzberechnung.
Falls die ersten M Grundwellen signifikant sind, insbesondere $p = 2, ..., M$ gilt, sollte die Testfrequenz $F_t$ so gewählt werden, dass das Frequenzband 2B um die Grundwelle, wo sich keine der ersten M Oberwellen herunterfalten, maximiert wird gemäß

$$(4)\quad B = \max_{F_t}\ \left\{ \min_{p = 2,...,M}\ \left\{ |F_t - fp| \right\} \right\}.$$

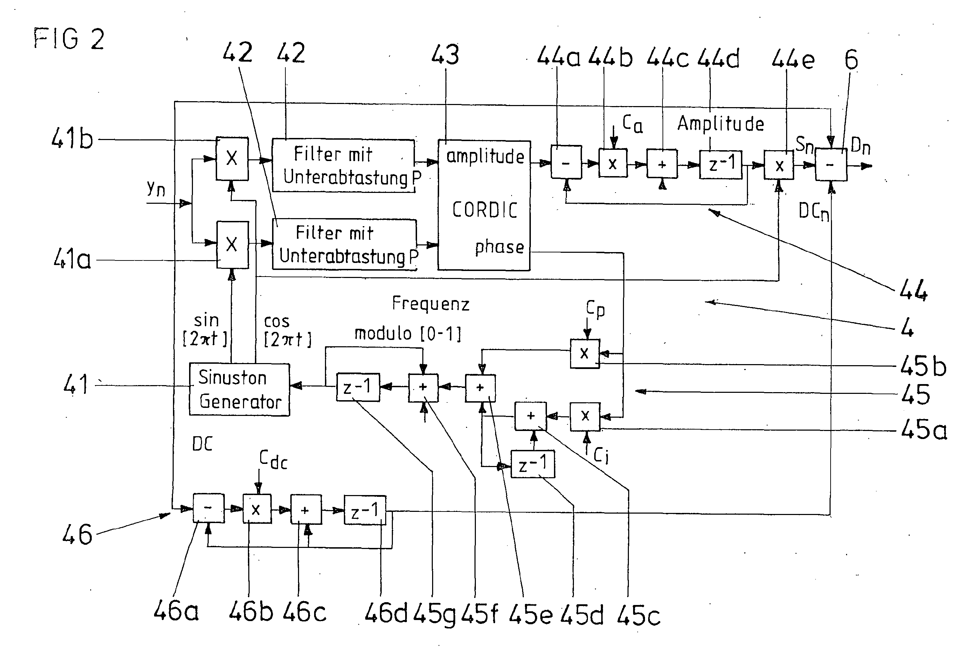

Die Extraktion des Testsignals bzw. der Abfolge der Ausgangssignal-Daten $S_n$ kann dann mit Hilfe eines für sich bekannten Verfahrens zur Trägeraufbereitung durchgeführt werden. Außerdem sollte berücksichtigt werden, dass das Testsignal s(t) bzw. die diesem zugeordnete Abfolge der Ausgangssignal-Daten $S_n$ amplitudengetreu ist.
Um dies zu erzielen, kann eine Schaltungsanordnung verwendet werden, welche auf einem I/Q-Demodulator (I:Inphase, Q:Quadraturphase) und einer Cordic-Schaltung 43 mit Berechnung von Phase und Amplitude der eingegebenen Abfolge digitaler Daten $y_n$ basiert. Eine beispielhafte Schaltungsanordnung entspricht der Darstellung aus Fig. 2.

Frequenz, Amplitude und Gleichstrom (DC: Direct Current) werden mittels einer für sich bekannten Verfahrensweise aus der Regelungstechnik durch Rückkopplung zurückgewonnen. Dabei wird für die Frequenzbestimmung eine vollständige PI-Regelung (PI: proportionale und integrale Anteile) eingesetzt. Für die Bestimmung von Amplitude und Gleichstrom wird eine P-Regelung benutzt, bei der nur die proportionalen Anteile verwendet werden. Als Regelungsparameter werden der P-Anteil der Amplitudenregelung $C_a$, der P-Anteil für die DC-Komponente $C_{dc}$ und die P- und I-Anteile der Frequenzregelung $C_p$ bzw. $C_i$ verwendet, welche gleichzeitig das Stabilitätskriterium einer Regelungsschleife erfüllen und eine möglichst schnelle Einschwingung gewährleisten sollen.

Die von der Kompensationsschaltung 2 ausgegebene Abfolge digitaler Daten $y_n$ wird der Testsignal-Überprüfungseinrichtung 4 zugeführt, wobei die zugeführte Abfolge der digitalen Daten $y_n$ zwei Multiplikationsgliedern 41a, 41b zugeführt wird. Dem ersten der Multiplikationsglieder 41a wird von einem Sinuston-Generator 41 ein sinusförmiges Signal $\sin[2\pi t]$ als zu multiplizierende Signalabfolge zugeführt. Dem zweiten Multiplikationsglied 41b wird entsprechend vom Sinuston-Generator eine cosinusförmige Signalabfolge $\cos[2\pi t]$ zugeführt. Nach der Multiplikation werden die beiden Datenfolgen jeweils einem Filter 42 mit einer Unterabtastung P zugeführt. Nach der Filterung werden die in I- bzw. Q-zerlegten Signalkomponenten der Cordic-Schaltung 43 zugeführt, welche zu den aus der Kompensationsschaltung 2 ausgegebenen Daten $y_n$ eine entsprechende Amplitude und eine entsprechende Phase bestimmt und über zwei Ausgänge bereitstellt.

Die Signal- bzw. Datenabfolge, welche die Amplitude repräsentiert, wird einer Abfolge aus Bauelementen 44 zugeführt. Diese bestehen aus einem Subtraktionsglied 44a, einem Multiplikationsglied 44b, einem Additionsglied 44c und einem invertierenden Glied ($z^{-1}$) 44e, dessen Ausgangssignal dem Subtraktionsglied 44a und dem Additionsglied 44c zugeführt wird. Dem Multiplikationsglied 44b wird ein Koeffizientenwert $C_a$ als Regelungsparameter für den P-Anteil der Amplitudenregelung zugeführt. Das Ausgangssignal dieser Abfolge von Bauelementen wird außerdem einem weiteren Multiplikationsglied 44e zugeführt, an dessen zweitem Eingang das Cosinus-Signal $\cos[2\pi t]$ des Sinuston-Generators 41 anliegt. Mit Hilfe dieser Anordnung wird letztendlich die Abfolge der Ausgangssignaldaten $S_n$ bestimmt, welche dann dem differenzbildenden Subtraktionsglied 6 zugeführt wird, welches über den zweiten Eingang die Abfolge der digitalen Daten $y_n$ zeitgleich angelegt bekommt.

Die Cordic-Schaltung 43 gibt neben der Amplitude auch eine entsprechende Phase bzw. eine Abfolge von Phasendaten aus. Diese werden ebenfalls einer Schaltungsanordnung aus einer Vielzahl von Bauelementen 45 zugeführt. Beim dargestellten Ausführungsbeispiel besteht diese Schaltungsanordnung aus zwei parallelen Multiplikationsgliedern 45b, 45a, welchen zusätzlich ein Koeffizientenwert $C_p$ bzw. ein Koeffizientenwert $C_i$ zugeführt wird. Das Ausgangssignal des letztgenannten Multiplikationsgliedes 45a wird einem Additionsglied 45c zugeführt, dessen Ausgangssignal einerseits einem Invertierungsglied ($z^{-1}$) 45d und andererseits einem weiteren Additionsglied 45e zugeführt wird. Das Ausgangssignal des Invertierungsglieds 45d wird dem zweiten Eingang des erstgenannten Additionsglieds 45c zugeführt. Das zweitgenannte Additionsglied 45e empfängt über den weiteren Eingang Daten von dem Multiplikationsglied 45b, bei welchem auf die Phasendaten der Koeffizientenwert $C_p$ aufmultipliziert wurde.

Die Ausgangsdaten dieses Additionsgliedes 45e werden einem weiteren Additionsglied 45f zugeführt, welches zwei zusätzliche Eingänge aufweist. Über den ersten zusätzlichen Eingang wird ein Frequenzverhältnis $F_t/F_s$ der Testfrequenz $F_t$ des AD-Wandlers 1 und der Abtastfrequenz zugeführt. Über den zweiten Eingang wird ein Ausgangswert eines dem Additionsglied 45f nachgeschalteten Invertierungsglied ($z^{-1}$) 45g zugeführt. Ausgangswerte dieses Invertierungsgliedes 45g werden als Zeitsteuergröße t einem Eingang des Sinuston-Generators 41 zugeführt.

Aus der von der Kompensationsschaltung 2 ausgegebenen Abfolge digitaler kompensierter Daten $y_n$ wird außerdem eine DC-Komponente $DC_n$ ausgefiltert und extrahiert. Dazu werden die digitalen kompensierten Daten $y_n$ einer Schaltungsanordnung 46 aus einem Subtraktionsglied 46a, einem Multiplikationsglied 46b, einem Additionsglied 46c und einem Invertierungsglied ($z^{-1}$) 46d zugeführt. Dem Multiplikationsglied 46b wird über den zweiten Eingang ein Regelungsparameter $C_{dc}$ angelegt. Der Regelungsparameter $C_{dc}$ bestimmt die Geschwindigkeit des Einschwingens. Die ausgegebene Datenfolge des Invertierungsglieds 46d wird einerseits den Eingängen des Subtraktionsglieds 46a und des Additionsglieds 46c und andererseits dem die Differenzdaten $D_n$ erzeugenden Subtraktionsglied 6 zugeführt.

Bei der Schaltungsanordnung gemäß Fig. 2 wird somit die Frequenz $F_t$ mittels einer phasengekoppelten Schleife (PLL) abgeleitet. Das Eingangssignal, welches der Abfolge kompensierter digitaler Daten $y_n$ entspricht, wird in I- und Q-Komponenten zerlegt, die weiter mit einem Tiefpassfilter 42 mit einer Grenzfrequenz B gefiltert und unterabgetastet werden. Aus den gefilterten I- und Q-Komponenten rechnet anschließend die Cordic-Schaltung 43 Amplitude und Phase zwischen dem Eingangssignal $y_n$ und dem lokal generierten Sinuston aus dem Sinuston-Generator 41 aus. Die Phase wird als Fehlersignal in die PI-Regelung geführt. Nach einer Einschwingzeit wird der Sinuston-Generator 41 in seinem Cosinus-Zweig ein mit dem Testton synchronisiertes Signal erzeugen. Die Koeffizienten $C_p$ und $C_i$ und die Testfrequenz $F_t$ als bekannte Parameter bestimmen die PI-Regelung.

Die Amplitude wird aus dem Amplituden-Ausgang der Cordic-Schaltung 43 mit Hilfe des Regelungsparameters $C_a$ iterativ abgeleitet. Die DC-Komponente wird aus dem Ausgangssignal mit dem Regelungsparameter $C_{dc}$ ausgefiltert und extrahiert. Die gesamte Schaltungsanordnung aus der Testsignal-Überprüfungseinrichtung 4 und dem nachgeschalteten Subtraktionsglied 6 erzeugt letztendlich eine Abfolge von Differenzdaten $D_n$ gemäß der Gleichung (3), welche zu den nicht-linearen Verzerrungen proportional sind.

Vorteilhafterweise kann für die Umsetzung einer solchen Schaltungsanordnung auf verfügbare Trägeraufbereitungsanordnungen und Trägeraufbereitungsverfahren zurückgegriffen werden. Hinzuzufügen sind die Schaltungsanordnungen für die Amplituden- und DC-Komponente.

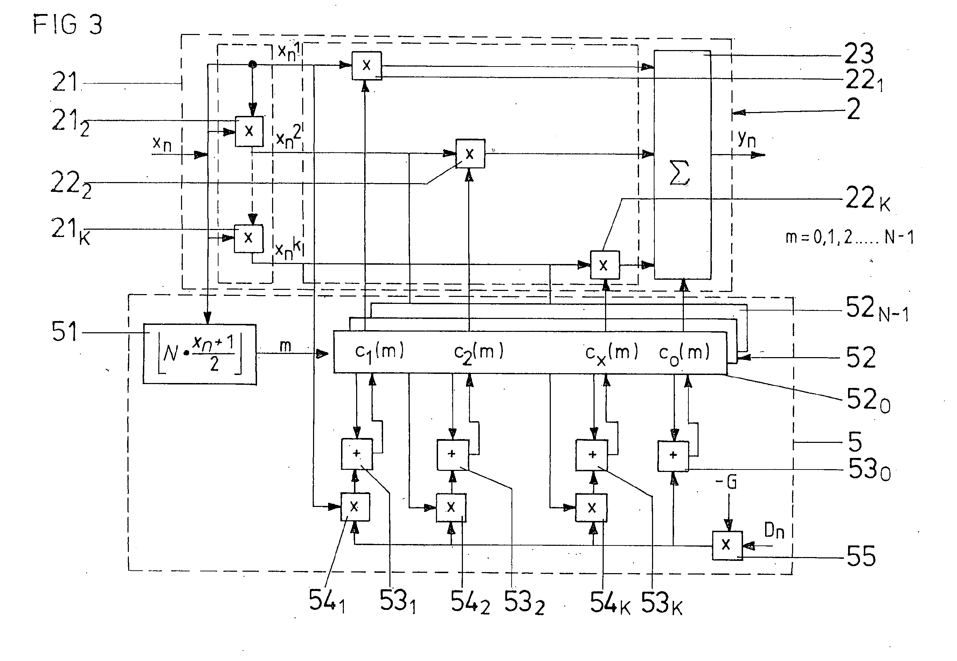

Eine besonders bevorzugte Ausführungsform der Kompensationsschaltung 2 ist segmentweise aufgebaut, wie dies aus Fig. 3 ersichtlich ist.

Die von dem AD-Wandler 1 ausgegebene Datenfolge $x_n$ wird in der Kompensationsschaltung 2 einer parallelen Anordnung von Multiplikationsgliedern 21 zugeführt. Dabei wird dem zweiten Eingang des ersten Multiplikationsglieds $21_2$ das gleiche Eingangssignal, d. h. nochmals der entsprechende Datenwert der Datenfolge $x_n$ zugeführt, so dass eine Quadrierung durchgeführt wird. Der Ausgang dieses ersten Multiplikationsglieds $21_2$ wird dem zweiten Eingang des zweiten Multiplikationsglieds $21_3$ und so weiter zugeführt, so dass mit jeder weiteren Stufe eine Erhöhung des Exponenten um den Wert 1 bis zu einem Wert $x_n^K$ vorgenommen wird.

Auf diese Art und Weise wird eine Potenzierung vorgenommen, wobei jede Potenzierungsstufe einen Ausgang aufweist, so dass Werte der digitalen Daten mit Potenzierungen von $x_n^1$, $x_n^2$, ..., $x_n^K$ aus dem Eingang und dem Feld von Multiplikationsgliedern 21 ausgegeben werden. Diese werden dann einem weiteren Feld von Multiplikationsgliedern 22 zugeführt, wobei eine Multiplikation mit jeweils einem entsprechenden der Koeffizienten $c_k(m)$ mit k = 1, 2, ..., K vorgenommen wird. Beschrieben wird somit eine mehrgliedrige Anordnung mit den Koeffizienten $c_k(m)$ der Kompensation in dem m-ten Segment mit m = 0, 1, 2, ..., N-1 als m-ten Segment des Amplitudenbereichs. So wird in das erste Multiplikationsglied $22_1$ des zweiten Multiplikationsfeldes 22 der nicht potenzierte Wert bzw. die nicht potenzierte Datenfolge $x_n^1$ sowie der Koeffizient $c_1(m)$ eingegeben. In das zweite Multiplikationsglied $22_2$ werden der einmalig potenzierte Datenwert $x_n^2$ sowie der zweite Koeffizient $c_2(m)$ eingegeben usw.. Die Ausgangswerte der Multiplikationsglieder $22_1$, $22_2$, ..., $22_K$ des zweiten Multiplikationsfeldes 22 werden einem Addierer 23 zugeführt, welcher eine Addierung sämtlicher Eingangswerte sowie zusätzlich des Null-ten Koeffizienten $c_0(m)$ durchführt und die Abfolge kompensierter digitaler Daten $y_n$ ausgibt.

Die vom AD-Wandler 1 ausgegebene Abfolge digitaler Daten $x_n$ wird außerdem der Koeffizienten-Bestimmungsanordnung 5 zugeführt, wobei eine Abrundungsoperation unter Berücksichtigung der N Segmente bei der Bestimmung des Index m in einer Index-Bestimmungseinrichtung 51 durchgeführt wird. Dabei wird die Abfolge digitaler Daten $x_n$ mit ihrem jeweiligen um 1 erhöhten Wert durch 2 dividiert und anschließend mit der Anzahl der Segmente N multipliziert. Der so jeweils erzeugte Segment-Index m wird dann einer Koeffizienten-Speicheranordnung 52 zugeführt, welche aus einer Vielzahl m paralleler Speicherkomponenten $52_0$, $52_1$, ..., $52_{N-1}$ besteht. In den einzelnen Segmenten dieser Koeffizienten-Speicheranordnung 52 sind jeweils die Koeffizienten $c_1(m)$, $c_2(m)$ , ..., $c_K(m)$ und $c_0(m)$ abgespeichert. Zu jedem abgespeicherten Index m gibt es einen Ausgang zu einem Additionsglied $53_1$, $53_2$, ..., $53_K$, $53_0$, dessen Ausgang wiederum zum selben Segment der Koeffizienten-Speicheranordnung 52 zurückgeführt wird. In den zweiten Eingang der Additionsglieder $53_1$, ... wird das Ergebnis eines Multiplikationsgliedes $54_1$, $54_2$, ..., $54_K$ eingegeben. Den Eingängen dieser Multiplikationsglieder $54_1$, $54_2$, ..., $54_K$ wird jeweils der entsprechend potenzierte Wert der Abfolge der digitalen Daten $x_n^1$, $x_n^2$, ... bzw. $x_n^K$ zugeführt. Dem jeweils zweiten Eingang der Multiplikationsglieder $54_1$, $54_2$, ..., $54_K$ wird das Ergebnis eines Multiplikationsgliedes 55 zugeführt, welchem einerseits die entsprechenden Werte der Differenzdaten $D_n$ und andererseits der negative als Stabilitätskriterium dienende Parameter -G zugeführt werden. Dem letzten Additionsglied $53_0$ wird an dessen zweitem Eingang lediglich der Wert der Differenzdaten $D_n$, multipliziert mit dem negativen Parameter -G, zugeführt.

Mit einer derartigen Schaltungsanordnung kann die Kompensationsschaltung 2 segmentweise realisiert werden. Der Bereich der Eingangsdatenwerte, d. h. der Abfolge digitaler Daten $x_n$, aus dem AD-Wandler 1 mit Datenwerten von -1 bis +1 wird auf N Segmente gleichmäßig aufgeteilt gemäß

$$-1 + \frac{2}{N}\, m \le x_n \le -1 + \frac{2}{N}\, (m + 1),$$

wobei der Segment-Index m zwischen 0 und N-1 liegt. Damit ist zu jedem Segment m ein Koeffizientensatz $\{c_0(m), c_1(m), ..., c_K(m)\}$ zugeordnet. Wegen der segmentalen Interpolation der Kennlinie werden Null-te Koeffizienten $c_0(m)$ hinzuaddiert, so dass für die aus der Kompensationsschaltung 2 ausgegebene Abfolge kompensierter digitaler Daten $y_n$ gilt:

$$(5) \quad y_n = \sum_{k=0}^{k} c_k(m) \cdot x_n^k \quad \text{mit} \quad m = \left\lfloor N \cdot \frac{x_n + 1}{2} \right\rfloor \quad,$$

wobei $\lfloor \ \rfloor$ die Abrundungsoperation darstellt.

Die Formel (5) zur Kompensation in der Kompensationsschaltung 2 und die iterative Berechnung der Koeffizienten gemäß Formel (3) lassen sich effektiv zusammen realisieren, wie dies anhand Fig. 3 skizziert ist. In einem Speicher der Größe N $\times$ (K+1), vorliegend der Koeffizienten-Speicheranordnung 52, werden N Sätze mit je K+1 Koeffizienten $c_1(m)$, $c_2(m)$, ..., $c_K(m)$ und $c_0(m)$ für jeweils m = 0, 1, 2, ..., N-1 abgespeichert. Bei jedem Abtastmoment wird der Index m aus dem Eingangssignal, d. h. dem anliegenden Wert der Abfolge digitaler Daten $x_n$, gemäß Formel (5) abgeleitet und dem entsprechenden Koeffizientensatz $52_0$, $52_1$, ..., $52_{N-1}$ zugeordnet und entsprechend in der Kompensationsschaltung 2 angewendet. Außerdem wird bei dieser Verfahrensweise für jeden Koeffizienten dessen abgespeicherter Wert iterativ gemäß Formel (3) verbessert und auf demselben Speicherplatz abgespeichert.

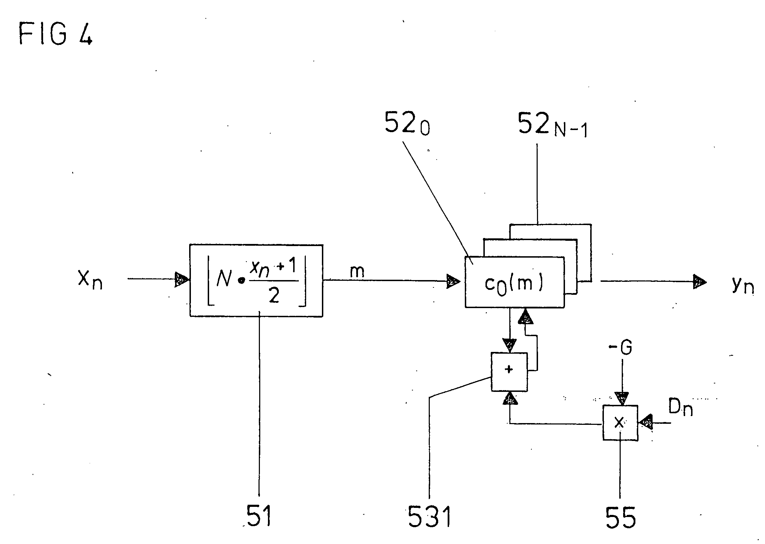

Wie dies aus Fig. 4 ersichtlich ist, kann das Verfahren mit der segmentalen Interpolation in einem bestimmten Fall mit N = $2^B$ vereinfacht werden. Dazu ist es erforderlich, dass die Anzahl N der Segmente mit der Auflösung des Signals bzw. der Abfolge der digitalen Daten $x_n$ übereinstimmt, also N = $2^B$ gilt, wobei B der Anzahl der Bit pro Abtastwert bei einem Signal-Bereich zwischen $-2^{B-1}$ und $2^{B-1}-1$ und nur einem Koeffizienten pro Segment, d. h. K = 0, entspricht.

Die Schaltung gemäß Fig. 3 reduziert sich dann zu der Schaltung gemäß Fig. 4, welche nach der Indexbestimmungseinrichtung 51 zum Bestimmen des Index'm eine Nachschlagtabelle mit $2^B$ adaptiven Koeffizienten $c_0(m)$ in den Speicherfeldern $52_0$, ..., $52_{N-1}$ aufweist. Bei dieser Anordnung entfallen sämtliche Multiplizierglieder 54, so dass nur die erste Additionsstufe mit den Additionsgliedern $53_1$, ... verbleibt, wie dies vorstehend beschrieben ist.

Erste synthetische Berechnungen mit einem Sinuston als Testsignal s(t) und einem mathematischen Modell der Analog-Digital-Kennlinie mit den verwendeten Frequenzen $F_s$ = 40,5 MHz, $F_t$ = 1,84 MHz, dem AD-Modell mit Koeffizienten für die Berechnung gemäß $0,9895x + 0,0028x^2 + 0,024x^3 - 0,0064x^4$ und für die Kompensation N = 1 Segmenten und einem maximalen Laufindex m mit K = 4 ergab deutliche Verbesserungen. Nach der Analog-Digital-Umwandlung zeigte sich ein anfänglicher Wert von -60,3 dB und nach der Kompensation ein Wert von - 80,9 dB, was eine Verbesserung von 20,5 dB ergab. Bei einer Messung (K3) zeigte sich eine Verbesserung von -47,2 dB nach der AD-Wandlung gegenüber -56,3 dB nach der Kompensation mit einer Verbesserung von 9,1 dB. Das Verhältnis der Verzerrungen zu den Leistungen ergab sich nach der AD-Wandlung mit -46,8 dB gegenüber -55,3 dB nach der Kompensation, was zu einer Verbesserung von 8,4 dB führte.

Anstelle einer Vielzahl von einzelnen Bauelementen, wie diese vorstehend beschrieben sind, kann natürlich auch eine Umsetzung in einem entsprechend geeigneten Rechnerbaustein oder in einem einstückig gefertigten Halbleiterbauelement als integrierte Schaltung oder dgl. vorgesehen werden.

**Patentansprüche**

**1.** Kompensationsschaltungsanordnung (1-6) zum Kompensieren von nicht-linearen Verzerrungen eines AD-Wandlers (1) (AD: Analog/Digital) mit

- einem Signaleingang und
- einer Kompensationsanordnung,

**gekennzeichnet durch**
eine digitale Kompensationsschaltung (2) mit dem Signaleingang als Digitalsignaleingang zum Zuführen nicht-linear verzerrter digitaler Daten ($x_n$) vom AD-Wandler (1).

**2.** Kompensationsschaltungsanordnung nach Anspruch 1 mit einer Koeffizienten-Bestimmungsanordnung (5, 21) zum Bestimmen adaptiver Koeffizienten ($c_1$, $c_2$, ..., $c_K$; $c_1(m)$, $c_2(m)$, ..., $c_K(m)$, $c_0(m)$) zum Kompensieren der nichtlinearen Verzerrungen in der Kompensationsschaltung (2).

**3.** Kompensationsschaltungsanordnung nach Anspruch 2 mit einer Steuereinrichtung zum Ein- und Ausschalten einer Konfigurationsphase zum Bestimmen aktueller adaptiver Koeffizienten ($c_1$, $c_2$, ..., $c_K$; $c_1(m)$, $c_2(m)$, ..., $c_K(m)$, $c_0(m)$).

**4.** Kompensationsschaltungsanordnung nach Anspruch 3 mit einer Zeitüberwachungseinrichtung (C, T) zum regelmäßigen Einschalten der Konfigurationsphase.

**5.** Kompensationsschaltungsanordnung nach einem der Ansprüche 2 - 4, bei der die Konfigurationsschaltungsanordnung (2 - 6) zum Erzeugen

- eines analogen Testsignals (s(t)) mit bekannten Testsignalparametern ($s_n$; $S_n$) ausgebildet ist und
- eine Verbindung zum Anlegen des analogen Testsignals (s(t)) an den Eingang des AD-Wandlers (1) und
- eine Verbindung zum Anlegen der Testsignalparameter ($s_n$; $S_n$) zum Weiterverarbeiten in zumindest der Koeffizienten-Bestimmungsanordnung (5) aufweist.

**6.** Kompensationsschaltungsanordnung nach Anspruch 5 mit einer Testsignal-Überprüfungseinrichtung (4) zum Extrahieren und Bestimmen der Signalabbildung ($S_n$) des analogen Testsignals (s(t)) aus den ausgegebenen digitalen kompensierten Daten ($y_n$) am Ausgang der Kompensationsschaltung (2) mit Hilfe der Testsignalparameter ($s_n$).

**7.** Kompensationsschaltungsanordnung nach Anspruch 6, bei der die Testsignal-Überprüfungseinrichtung (4) zum Bestimmen einer Testfrequenz ($F_t$) Schaltungselemente (41, 42, 43, 45) derart aufweist, dass ein Frequenzband (-B, B) um eine Grundwelle maximiert wird, so dass keine von signifikanten Oberwellen am Ausgang der Kompensationsschaltung (2) heruntergefaltet werden.

**8.** Kompensationsschaltungsanordnung nach Anspruch 7, bei der die Testsignal-Überprüfungseinrichtung (4) einen I/Q-Demodulator (41, 41a, 41b, I:Inphase, Q: Quadraturphase), eine Cordic-Schaltung (43) und eine Amplitudenabschätzungseinrichtung (44a - 44e) aufweist.

**9.** Kompensationsschaltungsanordnung nach einem der Ansprüche 6 - 8 mit einem Subtraktionsglied (6) zum Bilden von Differenzdaten ($D_n$) zwischen von der Kompensationsschaltung (2) ausgegebenen digitalen Daten ($y_n$) und der Signalabbildung ($S_n$) als Maß für nicht-lineare Verzerrungen.

**10.** Kompensationsschaltungsanordnung nach einem der Ansprüche 2 - 9, bei der die Koeffizienten-Bestimmungsanordnung (5, 21) zum iterativen Bestimmen der adaptiven Koeffizienten mit Minimierung des Quadrats der Differenzen eine Potentierungsanordnung (21) für vom AD-Wandler (1) ausgegebene Daten ($x_n$) aufweist.

**11.** Kompensationsschaltungsanordnung nach einem der Ansprüche 2 - 10, bei der die Koeffizienten-Bestimmungsanordnung (5, 21) und die Kompensationsschaltung (2) eine Vielzahl (N) gleichmäßiger Segmente aufweisen, denen jeweils ein Polynom mit Koeffizienten ($c_1(m)$, $c_2(m)$, ..., $c_K(m)$, $c_0(m)$) zugeordnet ist, wobei die Kompensationsschaltung eine Additionseinrichtung (23) zum Summieren über die Anzahl der Vielzahl von Segmenten aufweist.

**12.** Kompensationsschaltungsanordnung nach Anspruch 11, bei der die Kompensationsschaltung (2) und insbesondere die Koeffizienten-Bestimmungsanordnung (5) eine Koeffizientenspeicheranordnung (52, $52_0$, ..., $52_{N-1}$) zum Abspeichern von N Koeffizientensätzen mit je (K+1)-Koeffizienten zur Anwendung. in der Kompensationsschaltung (2) aufweist.

**13.** Kompensationsschaltungsanordnung nach Anspruch 11 oder 12, mit einer Index-Bestimmungseinrichtung (51) zum Bestimmen eines der Segmentvielzahl entsprechenden Index (m) des aktuellen Koeffizientensatzes (m = 0, 1, 2, ..., N-1) aus Eingangsdaten ($x_n$) der Kompensationsschaltung (2).

**14.** Kompensationsschaltungsanordnung nach einem der Ansprüche 2 - 13, mit einer Nachschlagtabelle ($52_0$, $52_1$, ... $52_{N-1}$) zum Bereitstellen der adaptiven Koeffizienten ($c_1(m)$, $c_2(m)$, ..., $c_{N-1}(m)$, $c_0(m)$).

**15.** Kompensationsschaltungsanordnung nach Anspruch 14, bei der die Nachschlagtabelle (52) eine Speicherplatzanzahl (N) gleich der Signalauflösung der zu kompensierenden Daten ($x_n$) aufweist.

**16.** Kompensationsschaltungsanordnung nach einem der Ansprüche 11 - 15, bei der die Koeffizienten-Bestimmungsanordnung (5, 21) zum Adressieren der adaptiven Koeffizienten ($c_1(m)$, $c_2(m)$, ...,

$c_{N-1}(m), c_0(m))$ auf Basis der Eingangsdaten ($x_n$) als Ausgangswerte für die Kompensationsschaltung (2) ausgebildet ist.

17. AD-Wandler-Schaltung mit

    - einem AD-Wandler (1) und
    - einer Kompensationsanordnung zum Kompensieren von nicht-linearen Verzerrungen des AD-Wandlers (1),

    **dadurch gekennzeichnet, dass**
    die Kompensationsanordnung, insbesondere eine Kompensationsschaltungsanordnung (2 - 6) nach einem vorstehenden Anspruch, als eine digitale, nicht-linear kompensierende Kompensationsschaltung (2) ausgebildet ist und
    die Kompensationsschaltung (2) dem AD-Wandler (1) nachgeschaltet ist.

18. Verfahren zum Kompensieren einer nicht-linearen Verzerrung eines AD-Wandlers (1), bei der

    - vom AD-Wandler (1) nicht-linear verzerrte Daten ($x_n$) ausgegeben werden und
    - die nicht-linear verzerrt ausgegebenen Daten ($x_n$) einer dem AD-Wandler (1) nachgeschalteten Kompensationsschaltung (2), insbesondere Kompensationsschaltungsanordnung (2 - 6) nach einem vorstehenden Anspruch, zum Kompensieren der nicht-linearen Verzerrung zugeführt werden.

19. Verfahren nach Anspruch 18, bei dem
    die nicht-lineare Kompensierung in der Kompensationsschaltung (2) mit Hilfe adaptiver Koeffizienten ($c_1, c_2, ..., c_K; c_1(m), c_2(m), ..., c_K(m), c_0(m)$) durchgeführt wird.

20. Verfahren nach Anspruch 19, bei dem

    - ein analoges Testsignal ($s(t)$) erzeugt und dem Analog-Eingang des AD-Wandlers (1) zugeführt wird und
    - mit Hilfe bekannter Testsignalparameter ($s_n; S_n$) aus den zu dem analogen Testsignal ($s(t)$) vom AD-Wandler (1) ausgegebenen digitalen Daten ($x_n, y_n$) die adaptiven Koeffizienten ($c_1, c_2, ..., c_K; c_1(m), c_2(m), ..., c_K(m), c_0(m)$) zur Anwendung in der Kompensationsschaltung (2) bestimmt werden.

21. Verfahren nach Anspruch 19 oder 20, bei dem
    die adaptiven Koeffizienten ($c_1, c_2, ..., c_K; c_1(m), c_2(m), ..., c_K(m), c_0(m)$) iterativ bestimmt werden.

22. Verfahren nach einem der Ansprüche 19 - 21, bei dem
    bei dem Bestimmen der adaptiven Koeffizienten ($c_1, c_2, ..., c_K; c_1(m), c_2(m), ..., c_K(m), c_0(m)$) das Quadrat der Differenz der vom AD-Wandler (1) ausgegebenen nicht-linear verzerrten digitalen Daten ($x_n$) gegenüber den durch die Kompensationsschaltung (2) mit Hilfe zuvor verwendeter adaptiver Koeffizienten bestimmt wird.

# FIG 1

analog | digital

x(t) → ADC | $x_n$ → Kompensations-schaltung | $y_n$ →

$C_1$ $C_2$ $C_K$ $C_0$

s(t)

koeffizienten-Bestimmungs anordnung | $D_n$ | $S_n$ | Testsignal-überprüfungs-einrichtung

Testsignal-Generator | $S_n$ →

C | T

Steuerbus

aktiv in Konfigurationsphase

1  2  3  5  6  7  4

EP 1 447 913 A1

FIG 2

FIG 3

FIG 4

$52_0$     $52_{N-1}$

$x_n \rightarrow$ $\left\lfloor N \cdot \dfrac{x_n + 1}{2} \right\rfloor$ $\xrightarrow{m}$ $c_0(m)$ $\rightarrow y_n$

$+$

$-G$

$\times \leftarrow D_n$

51     531     55

EP 1 447 913 A1

EP 1 447 913 A1

**Europäisches Patentamt**

# EUROPÄISCHER RECHERCHENBERICHT

Nummer der Anmeldung

EP 04 00 1903

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 2002/093439 A1 (LUNDIN HENRIK ET AL) 18. Juli 2002 (2002-07-18) * Abbildungen 3A,4A; Tabelle 1 * --- | 1-5, 10-22 | H03M1/10 |
| X | US 2002/196864 A1 (BOOTH RICHARD W D ET AL) 26. Dezember 2002 (2002-12-26) * Abbildung 2 * --- | 6-9 | |
| X | US 5 594 612 A (HENRION W S) 14. Januar 1997 (1997-01-14) * Abbildung 2 * --- | 1-5, 10-22 | |
| X | EP 0 460 840 A (GEN ELECTRIC) 11. Dezember 1991 (1991-12-11) * Abbildung 1 * --- | 1-5, 10-22 | |
| X | WO 01/61861 A (ENGL BERNHARD ;INFINEON TECHNOLOGIES AG (DE); MENKHOFF ANDREAS (DE) 23. August 2001 (2001-08-23) * Abbildung 1 * --- | 1-5, 10-22 | |
| A | MACLEOD M D: "FAST CALIBRATION OF IQ DIGITISER SYSTEMS" ELECTRONIC ENGINEERING, MORGAN-GRAMPIAN LTD. LONDON, GB, Bd. 62, Nr. 757, 1990, Seiten 41-42,45, XP000086171 ISSN: 0013-4902 * das ganze Dokument * --- | 1-22 | RECHERCHIERTE SACHGEBIETE (Int.Cl.7) H03M |
| A | US 2002/009164 A1 (DANTONI FRANCESCO ET AL) 24. Januar 2002 (2002-01-24) * Absatz [0003] * --- | 1-22 | |
| X | US 5 561 716 A (BARTELS STEFAN DR ET AL) 1. Oktober 1996 (1996-10-01) * Abbildung 1 * --- -/-- | 6-9 | |

Der vorliegende Recherchenbericht wurde für alle Patentansprüche erstellt

| Recherchenort | Abschlußdatum der Recherche | Prüfer |
|---|---|---|
| MÜNCHEN | 11. Mai 2004 | Müller, U |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................................
& : Mitglied der gleichen Patentfamilie, übereinstimmendes Dokument

EPO FORM 1503 03.82 (P04C03)

15

**Europäisches Patentamt**

# EUROPÄISCHER RECHERCHENBERICHT

Nummer der Anmeldung

EP 04 00 1903

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | DE 197 20 766 A (MICRONAS SEMICONDUCTOR HOLDING) 26. November 1998 (1998-11-26) * Abbildung 8 * --- | 1-22 | |
| A | EP 0 486 095 A (PHILIPS NV) 20. Mai 1992 (1992-05-20) * Abbildung 1 * --- | 1-22 | |
| A | EP 1 217 746 A (ST MICROELECTRONICS SRL) 26. Juni 2002 (2002-06-26) * Abbildung 4 * ----- | 1-22 | |

RECHERCHIERTE SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| MÜNCHEN | 11. Mai 2004 | Müller, U |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**   EP 04 00 1903

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-05-2004

| Im Recherchenbericht angeführtes Patentdokument | Datum der Veröffentlichung | Mitglied(er) der Patentfamilie | | Datum der Veröffentlichung |
|---|---|---|---|---|
| US 2002093439 A1 | 18-07-2002 | US | 6407685 B1 | 18-06-2002 |
| | | US | 6127955 A | 03-10-2000 |
| | | US | 2001010500 A1 | 02-08-2001 |
| | | AU | 2286102 A | 24-06-2002 |
| | | EP | 1342323 A2 | 10-09-2003 |
| | | WO | 0249217 A2 | 20-06-2002 |
| | | AU | 7472801 A | 02-01-2002 |
| | | CA | 2410444 A1 | 27-12-2001 |
| | | EP | 1293043 A1 | 19-03-2003 |
| | | JP | 2003536342 T | 02-12-2003 |
| | | WO | 0199282 A1 | 27-12-2001 |
| | | AU | 769594 B2 | 29-01-2004 |
| | | AU | 1590800 A | 13-06-2000 |
| | | CA | 2349259 A1 | 02-06-2000 |
| | | CN | 1333948 T | 30-01-2002 |
| | | EP | 1133828 A1 | 19-09-2001 |
| | | JP | 2002530988 T | 17-09-2002 |
| | | WO | 0031876 A1 | 02-06-2000 |
| | | AU | 2125502 A | 24-06-2002 |
| | | EP | 1344319 A2 | 17-09-2003 |
| | | WO | 0249216 A2 | 20-06-2002 |
| US 2002196864 A1 | 26-12-2002 | KEINE | | |
| US 5594612 A | 14-01-1997 | FR | 2725328 A1 | 05-04-1996 |
| | | JP | 8204559 A | 09-08-1996 |
| EP 0460840 A | 11-12-1991 | US | 5047772 A | 10-09-1991 |
| | | CA | 2042142 A1 | 05-12-1991 |
| | | CN | 1057136 A | 18-12-1991 |
| | | EP | 0460840 A2 | 11-12-1991 |
| | | JP | 5083134 A | 02-04-1993 |
| | | KR | 9405935 B1 | 24-06-1994 |
| WO 0161861 A | 23-08-2001 | DE | 10007408 A1 | 06-09-2001 |
| | | WO | 0161861 A2 | 23-08-2001 |
| | | US | 2003052803 A1 | 20-03-2003 |
| US 2002009164 A1 | 24-01-2002 | KEINE | | |
| US 5561716 A | 01-10-1996 | DE | 4340012 A1 | 01-06-1995 |
| | | JP | 7202574 A | 04-08-1995 |
| DE 19720766 A | 26-11-1998 | DE | 19720766 A1 | 26-11-1998 |
| EP 0486095 A | 20-05-1992 | NL | 9002489 A | 01-06-1992 |

EPO FORM P0461

Für nähere Einzelheiten zu diesem Anhang : siehe Amtsblatt des Europäischen Patentamts, Nr.12/82

## ANHANG ZUM EUROPÄISCHEN RECHERCHENBERICHT
## ÜBER DIE EUROPÄISCHE PATENTANMELDUNG NR.

EP 04 00 1903

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-05-2004

| Im Recherchenbericht angeführtes Patentdokument | | Datum der Veröffentlichung | Mitglied(er) der Patentfamilie | | Datum der Veröffentlichung |
|---|---|---|---|---|---|
| EP 0486095 | A | | AT | 148963 T | 15-02-1997 |
| | | | DE | 69124663 D1 | 27-03-1997 |
| | | | DE | 69124663 T2 | 31-07-1997 |
| | | | EP | 0486095 A1 | 20-05-1992 |
| | | | ES | 2100203 T3 | 16-06-1997 |
| | | | FI | 915331 A | 16-05-1992 |
| | | | JP | 3181645 B2 | 03-07-2001 |
| | | | JP | 6037664 A | 10-02-1994 |
| | | | KR | 209386 B1 | 15-07-1999 |
| | | | US | 5230011 A | 20-07-1993 |
| EP 1217746 | A | 26-06-2002 | EP | 1217746 A1 | 26-06-2002 |
| | | | US | 2002126028 A1 | 12-09-2002 |

EPO FORM P0461

Für nähere Einzelheiten zu diesem Anhang : siehe Amtsblatt des Europäischen Patentamts, Nr.12/82